# EUROPÄISCHE PATENTSCHRIFT

(11) **EP 1 200 651 B1**
(45) Veröffentlichungstag und Bekanntmachung des Hinweises auf die Patenterteilung: **07.04.2004**
(21) Anmeldenummer: 00952900.9
(22) Anmeldetag: 04.07.2000
(51) Int. Cl.: C30B 23/00

(54) **KEIMKRISTALLHALTER MIT SEITLICHER EINFASSUNG EINES SIC-KEIMKRISTALLS**
SEED CRYSTAL HOLDER WITH A LATERAL BORDER FOR AN SIC SEED CRYSTAL
PORTE-CRISTAL GERME AVEC BORDURE LATERALE POUR UN CRISTAL GERME DE SIC

(30) Priorität: 07.07.1999 DE 19931336
(43) Veröffentlichungstag der Anmeldung: 02.05.2002
(73) Patentinhaber: SIEMENS AKTIENGESELLSCHAFT, 80333 München (DE)
(72) Erfinder: STEIN, Rene, D-91341 Röttenbach (DE); KUHN, Harald, D-91056 Erlangen (DE); VÖLKL, Johannes, D-91056 Erlangen (DE); ZINTL, Wolfgang, D-91052 Erlangen (DE)
(86) Internationale Anmeldenummer: PCT/DE2000/002171
(87) Internationale Veröffentlichungsnummer: WO 2001/004390

(56) Entgegenhaltungen:
- EP-A- 0 801 155
- WO-A-00/22203
- JP-A- 1 305 898
- US-A- 5 858 086
- US-A- 6 045 613
- PATENT ABSTRACTS OF JAPAN vol. 014, no. 184 (C-0709), 13. April 1990 (1990-04-13) & JP 02 030699 A (NIPPON STEEL CORP), 1. Februar 1990 (1990-02-01) in der Anmeldung erwähnt
- PATENT ABSTRACTS OF JAPAN vol. 1997, no. 01, 31. Januar 1997 (1997-01-31) & JP 08 245299 A (SANYO ELECTRIC CO LTD), 24. September 1996 (1996-09-24)

## Beschreibung

Die Erfindung betrifft einen Keimkristallhalter zur Halterung eines Siliciumcarbid (SiC)-Keimkristalls innerhalb eines Tiegels während einer Züchtung eines auf eine Vorderseite des SiC-Keimkristalls aufwachsenden SiC-Volumeneinkristalls. Die Züchtung erfolgt dabei insbesondere über ein Sublimationsverfahren.

Bei der Sublimationszüchtung von einkristallinem Siliciumcarbid kommen derzeit zwei in ihrem Aufbau grundsätzlich verschiedene Tiegelausführungsformen zum Einsatz. Bei einer ersten Ausführungsform befindet sich ein Vorrat aus festem, zu sublimierendem Siliciumcarbid in einem oberen Tiegelbereich und der SiC-Keimkristall, auf dem das aus dem Vorrat sublimierte Siliciumcarbid in Form eines SiC-Volumeneinkristalls aufwächst, in einem unteren Tiegelbereich. Eine solche erste Tiegelausführungsform ist z.B. in der *DE 32 30 727* C2 offenbart. Da der SiC-Keimkristall hierbei einfach auf dem Boden des Tiegels aufliegen kann, ist keine besonders ausgestaltete Keimkristallhalterung notwendig. Andererseits besteht bei dieser Tiegelausführungsform die Gefahr, daß ein festes SiC-Partikel z.B. aus dem Vorrat auf den aufwachsenden SiC-Volumeneinkristall fällt und eine Störung des Kristallwachstums hervorruft.

In der *WO 94*/*23096 A1* oder auch in dem Aufsatz *Materials Science and Engineering*, *Vol*. *B29, 1995, Seiten 90 bis 93* wird dagegen eine zweite Ausführungsform des Tiegels beschrieben, die diesen Nachteil dadurch umgeht, daß der SiC-Keimkristall im oberen Tiegelbereich und der SiC-Vorrat im unteren Tiegelbereich angeordnet sind. Es wird jedoch nicht genauer ausgeführt, wie eine derartige hängende Befestigung des SiC-Keimkristalls im oberen Tiegelbereich ausgeführt ist.

Ein weiterer Keimkristallhalter zur hängenden Halterung eines SiC-Keimkristalls ist in dem *Patentabstract zur JP 02-030699 A* beschrieben.

Mit der *WO 97*/*07265 A1* wird eine Beschichtung für den SiC-Keimkristall offenbart, die chemisch stabil gegenüber dem Material des SiC-Keimkristalls und gegengüber der aus dem sublimierten SiC des Vorrats gebildeten SiC-Gasphase ist. Darüber hinaus schmilzt oder sublimiert diese Beschichtung auch bei der während der Züchtung herrschenden Temperatur von über 2000°C noch nicht. Außerdem eignet sich diese Beschichtung auch für eine hängende Anordnung des SiC-Keimkristalls. Der SiC-Keimkristall wird nämlich mit Hilfe einer Zuckerlösung an den Keimkristallhalter geklebt. Da eine solche Zuckerlösung jedoch eine relativ schlechte Wärmeankopplung an den Keimkristallhalter aufweist, besteht bei dieser Ausführungsform die Gefahr, daß sich ein unerwünschter Temperaturgradient innerhalb des SiC-Keimkristalls ausbildet und somit ein gestörtes Kristallwachstum resultiert.

In der *US 5,679,153* wird ein SiC-Substrat, das sich in einer Halterung befindet, von oben in eine Schmelze, die unter anderem Siliciumcarbid und reines Silicium enthält, eingetaucht. Bei dem offenbarten Verfahren handelt es sich um kein Verfahren zur Züchtung eines SiC-Volumeneinkristalls sondern vielmehr um ein Flüssigphasenepitaxie(LPE)-Verfahren, bei dem auf einem SiC-Substrat lediglich eine dünne epitaktische SiC-Schicht hergestellt wird. Da bei einem Sublimationsprozeß zur Herstellung eines SiC-Volumeneinkristalls der SiC-Keimkristall nicht in eine Schmelze eingetaucht wird und außerdem auch grundsätzlich andere Anforderungen in bezug auf eine Wärmeankopplung des SiC-Keimkristalls an die Halterung als bei einem LPE-Verfahren vorliegen, läßt sich die offenbarte Halterung auch nicht bei einem Sublimationsprozeß zur Herstellung eines SiC-Volumeneinkristalls verwenden.

Auch ein Einklemmen des SiC-Volumeneinkristalls zur hängenden Befestigung innerhalb des üblicherweise aus Graphit gefertigten Tiegels führt aufgrund des sehr kleinen SiC-Wärmeausdehnungskoeffizienten von 3·10⁻⁶ K⁻¹ gegebenenfalls zu Schwierigkeiten mit dem dauerhaften Sitz einer solchen Klemmung. Da das Graphit des Tiegels einen größeren Ausdehnungskoeffizienten besitzt, besteht die Möglichkeit, daß sich der geklemmte SiC-Keimkristall aus der Halterung löst und herabfällt. Aber auch, wenn der SiC-Keimkristall während der Züchtung nur etwas in der Klemmhalterung verrutscht, kann dadurch das Kristallwachstum beeinträchtigt werden.

In der US 5,858,086 wird eine Vorrichtung zur Züchtung eines Aluminiumnitrid-Einkristalls beschrieben, die einen Keimkristallhalter mit guten Wärmeleitungseigenschaften umfaßt. Ein Keimkristall wird im Keimkristallhalter eingefaßt und durch einen, aus der seitlichen Einfassung des Keimkristallhalters seitwärts und unterhalb der Vorderseite des Keimkristalls herausragenden kreisförmigen Vorsprung festgehalten. Die Rückseite des Keimkristalls befindet sich in Kontakt mit einer Stirnseite eines Wärmeabführungselements.

Der Erfindung liegt die Aufgabe zugrunde, einen Keimkristallhalter zur Halterung eines SiC-Keimkristalls innerhalb eines Tiegels während einer Züchtung eines auf eine Vorderseite des SiC-Keimkristalls aufwachsenden SiC-Volumeneinkristalls anzugeben, der sich zur Züchtung eines defektarmen und hochqualitativen SiC-Volumeneinkristalls eignet. Insbesondere soll der Keimkristallhalter auch stabil gegenüber der während der Züchtung herrschenden SiC-Gasphase sein.

Zur Lösung der Aufgabe wird ein Keimkristallhalter entsprechend den Merkmalen des Patentanspruchs 1 angegeben.

Der Keimkristallhalter zur Halterung eines SiC-Keimkristalls innerhalb eines Tiegels während einer Züchtung eines auf eine Vorderseite des SiC-Keimkristalls mittels einer SiC-Gasphase aufwachsenden SiC-Volumeneinkristalls umfaßt mindestens
- einen Rückseitenkörper mit einer Auflagefläche für eine Rückseite des SiC-Keimkristalls und
- eine seitliche Einfassung für den Rückseitenkörper und den SiC-Keimkristall, wobei
- die seitliche Einfassung wenigstens einen Vorsprung enthält, auf dem der SiC-Keimkristall in einem Randbereich seiner Vorderseite aufliegt, und
- die seitliche Einfassung mit einer Schicht versehen ist, die aus einem gegenüber den Komponenten der SiC-Gasphase chemisch stabilen und bei einer während der Züchtung herrschenden Temperatur nichtschmelzenden Material der Gruppe von Tantal, Wolfram, Niob, Molybdän, Rhenium, Iridium, Ruthenium, Hafnium und Zirkon oder aus einem solchen Material mit wenigstens einem Element der Gruppe besteht.

Die Erfindung beruht dabei auf der Erkenntnis, daß ein für die Züchtung eines SiC-Volumeneinkristalls geeigneter Keimkristallhalter neben einer ausreichenden mechanischen Fixierung auch stets eine gute Wärmeankopplung an der Rückseite des insbesondere scheibenförmigen SiC-Keimkristalls gewährleisten sollte. Diese Wärmeankopplung ergibt sich durch den vorgesehenen Rückseitenkörper, der mit der Rückseite des SiC-Keimkristalls in Kontakt steht. Da er keine mechanische Haltefunktion erfüllt, kann er ausschließlich mit Blick auf eine gute Wärmeankopplung des SiC-Keimkristalls ausgelegt werden. Insbesondere ist der Rückseitenkörper wärmeabführend, d.h. er sorgt für eine ausreichende Wärmeabfuhr aus dem SiC-Keimkristall und dem darauf aufwachsenden SiC-Volumeneinkristall.

Die mechanische Fixierung erfolgt dagegen über die seitliche Einfassung, auf deren Vorsprung der SiC-Keimkristall aufliegt und somit sicher im oberen Bereich des Tiegels fixiert werden kann. Die geometrischen Abmessungen der seitlichen Einfassung und des Rückseitenkörpers sind so auf den zu halternden SiC-Keimkristall abgestimmt, daß der Rückseitenkörper mit dem SiC-Keimkristall in Kontakt steht. Der Rückseitenkörper kann z.B. einfach auf dem SiC-Keimkristall aufliegen, es kann jedoch auch über eine entsprechende Wahl der geometrischen Abmessungen ein vorbestimmter Anpreßdruck zwischen dem SiC-Keimkristall und dem Rückseitenkörper eingestellt werden. In jedem Fall ist eine gute Wärmeankopplung des SiC-Keimkristalls an den Rückseitenkörper gewährleistet.

Der Vorsprung der Einfassung kann den SiC-Keimkristall entweder auf der Vorderseite in einem Randbereich oder an einem in den SiC-Keimkristall geschliffenen Randabsatz halten. Die seitliche Einfassung verläuft im wesentlichen parallel zu einer Dickenrichtung des SiC-Keimkristalls und damit auch zu einer Wachstumsrichtung des aufwachsenden SiC-Volumeneinkristalls.

Aufgrund der Beschichtung der seitlichen Einfassung mit einem chemisch stabilen und hochschmelzendem Material kommt es an der Kontaktfläche der seitlichen Einfassung zum SiC-Keimkristall zu keiner thermischen Degradation des SiC-Keimkristalls. Folglich wird die Qualität des aufwachsenden SiC-Volumeneinkristalls durch diesen ansonsten gegebenenfalls auftretenden Effekt nicht gemindert.

Um den Keimkristallhalter mit dem SiC-Keimkristall bestücken zu können, ist er insbesondere zerlegbar und zusammensetzbar, d.h. er enthält mindestens zwei mechanisch voneinander unabhängige Elemente. Bei einer Ausführungsform sind der Rückseitenkörper und die seitliche Einfassung als separate Elemente ausgebildet. Der SiC-Volumeneinkristall wird als erstes in die seitliche Einfassung gelegt, so daß seine Vorderseite bis auf den durch den Vorsprung bedeckten Bereich offen zugänglich ist. An diesem offen zugänglichen Bereich wächst während der Züchtung der SiC-Volumeneinkristall auf. Als zweites wird der Rückseitenkontakt auf die Rückseite des SiC-Keimkristalls gelegt und die seitliche Einfassung an der oberen Tiegelwand montiert.

Ebenso kann der Keimkristallhalter jedoch in einer anderen Ausführungsform mindestens zwei zusammensetzbare Halbschalenelemente enthalten, in die der SiC-Keimkristall eingesetzt werden kann. Auch bei dieser Ausführungsform sind die seitliche Einfassung und der Rückseitenkontakt vorhanden, wenn auch nicht als separate Elemente, sondern nur als entsprechende Funktionselemente.

Typischerweise hat der aufwachsende SiC-Volumeneinkristall eine Länge von mindestens 1 mm, insbesondere von mindestens 5 mm. Bevorzugt wird ein möglichst großer SiC-Volumeneinkristall gezüchtet.

Besondere Ausgestaltungen des Keimkristallhalters ergeben sich aus den abhängigen Ansprüchen.

Vorteilhaft ist eine Ausführungsform, bei der der Vorsprung der seitlichen Einfassung eine ersten Abschrägung aufweist, die sich auf einer von dem SiC-Keimkristall abgewandten Seite des Vorsprungs befindet. Dadurch nimmt eine Wandstärke des Vorsprungs in Richtung des Zentrums des zu halternden SiC-Keimkristalls immer mehr ab und läuft in einem spitzen Winkel aus. Eine derartige erste Abschrägung verhindert, daß der aufwachsende SiC-Volumeneinkristall mit dem Material des Vorsprungs verwächst. Dies ist insbesondere auch deshalb sehr vorteilhaft, da sich eine Querschnittsfläche des SiC-Volumeneinkristalls üblicherweise mit zunehmender Wachstumsdauer leicht vergrößert. Damit läßt sich der SiC-Volumeneinkristall nach abgeschlossenem Wachstum leichter aus dem Keimkristallhalter entnehmen.

Bevorzugt ist auch eine weitere Ausführungsform, bei der der Vorsprung an einer dem SiC-Keimkristall zugewandten Seite eine zweite Abschrägung aufweist. Wenn auch der SiC-Keimkristall dann mit einer entsprechend komplementären dritten Abschrägung angeschliffen ist, erhält man damit einen besonders guten Sitz des SiC-Keimkristalls in dem Keimkristallhalter. Günstig ist es auch, wenn der SiC-Keimkristall so angeschliffen ist, daß seine Oberfläche, auf der der SiC-Volumeneinkristall aufwächst, etwas über den unteren Rand der seitlichen Einfassung hinausragt. Dies kann entweder über eine entsprechende dritte Abschrägung oder einen Randabsatz am SiC-Keimkristall erreicht werden.

Bei einer Ausführungsform ist Graphit als hauptsächlich für die seitliche Einfassung und den Rückseitenkörper verwendetes Material vorgesehen. Graphit ist ein sehr hitzebeständiger Stoff und eignet sich deshalb auch sehr gut für den Einsatz bei der hohen Prozeßtemperatur während der Sublimationszüchtung von einkristallinem Siliciumcarbid. Insbesondere kann der Graphit in Form von hochreinem Elektrographit vorliegen.

Eine weitere vorteilhafte Ausgestaltung zeichnet sich dadurch aus, daß der Rückseitenkörper mit einer hitzebeständige Schicht versehen ist, auf der der SiC-Keimkristall aufliegt. Diese Schicht besteht insbesondere aus einem Material, das chemisch stabil gegenüber dem Material des SiC-Keimkristalls und den Komponenten der SiC-Gasphase ist sowie bei der verwendeten Prozeßtemperatur nicht schmilzt und auch nicht sublimiert. Die Schicht kann daher aus einem Material der Gruppe von Tantal, Wolfram, Niob, Molybdän, Rhenium, Iridium, Ruthenium, Hafnium und Zirkon bestehen oder zumindest ein Material der Gruppe enthalten. Insbesondere kann die Schicht auch ein Carbid eines der genannten hochschmelzenden Materialien enthalten.

Eine derartige Schicht, die sich insbesondere mindestens im Bereich der Auflagefläche des SiC-Keimkristalls auf dem Rückseitenkörper befindet, verhindert eine thermische Zersetzung (Degradation des SiC-Keimkristalls) an seiner von der Wachstumsfläche abgewandten Rückseite. Eine solche thermische Degradation kann bewirken, daß sich ein ursprünglich nur an der Rückseite des SiC-Keimkristalls vorhandener Defekt durch den kompletten SiC-Keimkristall hindurch bis in den aufwachsenden SiC-Volumeneinkristall ausbreitet und dort die erreichbare Qualität des gezüchteten SiC-Volumeneinkristalls beeinträchtigt. Die Schicht verhindert insbesondere ein Ausdiffundieren von Silicium aus dem SiC-Keimkristall in den Keimkristallhalter sowie eine chemische Reaktion von Silicium aus dem SiC-Keimkristall mit dem Material des Keimkristallhalters. Die Schicht kann als entsprechende Beschichtung des Rückseitenkörpers oder auch als lose Einlage zwischen dem Rückseitenkörper und dem SiC-Keimkristall, z.B. in Form einer Folie, ausgebildet sein.

Alternativ kann auch der SiC-Keimkristall mit einer derartigen Schicht versehen sein. Eine Beschichtung von Rückseitenkörper und seitlicher Einfassung ist dann nicht notwendig.

Bevorzugt ist eine Ausführungsform, bei der der Keimkristallhalter eine im wesentlichen runde Querschnittsgeometrie aufweist. Dies gilt insbesondere auch für den Rückseitenkörper und für die seitliche Einfassung. Diese Geometrieform ist unter anderem durch die üblicherweise ebenfalls runde Querschnittsfläche des SiC-Keimkristalls begründet. Die seitliche Einfassung kann insbesondere eine zylinderförmige Gestalt annehmen, in deren Innenraum der SiC-Keimkristall und der Rückseitenkörper plaziert werden können. Der Vorsprung am unteren Ende der seitlichen Einfassung hat dann die Form einer Ringblende.

Es gibt jedoch auch eine andere Ausführungsform, bei der der Rückseitenkörper und der scheibenförmige SiC-Keimkristall mit jeweils runder Querschnittsfläche durch eine seitliche Einfassung in Form zweier Stege gehalten werden. Bei dieser Ausführungsform nimmt der Vorsprung am unteren Ende der beiden Stege dann die Form einer Nase an, auf der der SiC-Keimkristall aufliegt.

Eine weitere vorteilhafte Ausgestaltung bezieht sich auf die Halterung eines fehlorientierten SiC-Keimkristalls. Durch eine solche gezielt vorgegebene Fehlorientierung bilden sich nämlich an einer Oberfläche des SiC-Keimkristalls im wesentlichen parallel orientierte Stufen mit einer Stufenhauptrichtung aus.

Zu Beginn des Kristallwachstums lagert sich anfangs das aufwachsende einkristalline Siliciumcarbid zunächst in den Stufenkehlen der fehlorientierten Keimkristalloberfläche an. Die Stufen scheinen sich dann zu bewegen oder auch zu fließen. Man spricht in diesem Zusammenhang auch vom sogenannten Stufenfluß ("step flow"), der praktisch senkrecht zur Stufenhauptrichtung erfolgt. Es wurde nun erkannt, daß ein großer Teil der beim Kristallwachstum auftretenden Störungen seinen Ausgangspunkt an der Halterung hat und dann von dort aus vorzugsweise in Richtung des Stufenflusses in den SiC-Volumeneinkristall hineinwächst. Deshalb ist es vorteilhaft, einen fehlorientierten SiC-Keimkristall mit stufenförmig strukturierter Vorderseite über die beiden Stege so zu haltern, daß eine Verbindungslinie zwischen den beiden Stegen im wesentlichen parallel (= längs) zur Stufenhauptrichtung, d.h. im wesentlichen senkrecht zur Richtung des Stufenflusses, verläuft. Wirkungslinien der beiden Stege verlaufen bei dieser Ausführungsform parallel. Das seitliche Einwachsen von Störungen in den SiC-Volumeneinkristall wird dadurch erheblich reduziert.

Eine weitere Reduzierung dieser Art der Defektbildung wird in einer anderen vorteilhaften Ausgestaltung dadurch erreicht, daß Wirkungslinien der beiden Stege nicht parallel verlaufen, sondern einen stumpfen Winkel einschließen. Der von den Wirkungslinien gebildete stumpfe Winkel hat dabei vorzugsweise einen Wert, der kleiner als 180° und größer als 100° ist.

In der Praxis werden die einzelnen Stufen nicht exakt parallel zueinander verlaufen und auch nicht jeweils die gleiche Stufenbreite aufweisen. Es lassen sich jedoch Mittelwerte für die Ausrichtung der Stufen und für ihre Breite angeben. Diese Mittelwerte werden hier mit Stufenhauptrichtung bzw. Stufenhauptbreite bezeichnet.

Bevorzugte Ausführungsbeispiele werden nunmehr anhand der Zeichnung näher erläutert. Zur Verdeutlichung ist die Zeichnung nicht maßstäblich ausgeführt und gewisse Merkmale sind schematisiert dargestellt. Im einzelnen zeigen:
- Figur 1: einen ersten Keimkristallhalter,
- Figur 2: einen zweiten Keimkristallhalter,
- Figur 3: einen dritten Keimkristallhalter,
- Figur 4: eine Ansicht von unten auf die Keimkristallhalter der Figuren 1 bis 3,
- Figur 5: einen Querschnitt durch einen fehlorientierten SiC-Keimkristall,
- Figur 6: einen ersten Keimkristallhalter für einen fehlorientierten SiC-Keimkristall und
- Figur 7: einen zweiten Keimkristallhalter für einen fehlorientierten SiC-Keimkristall.

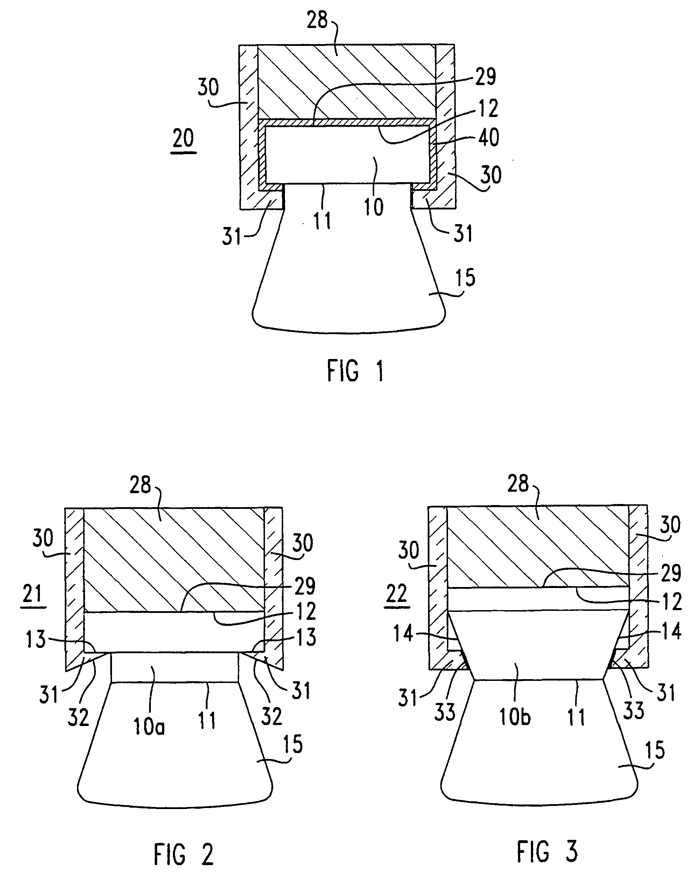

Einander entsprechende Teile sind in den Figuren 1 bis 7 mit denselben Bezugszeichen versehen.

In Figur 1 ist ein erster Keimkristallhalter 20 zum Einsatz im Rahmen einer Sublimationszüchtung eines SiC-Volumeneinkristalls 15 in Schnittdarstellung gezeigt. Der Keimkristallhalter 20 dient dabei der mechanischen Fixierung eines SiC-Keimkristalls 10 in einem oberen Bereich, insbesondere an einer oberen Wand eines nicht dargestellten Züchtungstiegels. Der SiC-Volumeneinkristall 15 wächst auf einer Vorderseite 11 SiC-Keimkristalls 10 auf.

Benachbart zu einer von der Vorderseite 11 abgewandten Rückseite 12 des SiC-Keimkristalls 10 ist ein Rückseitenkörper 28 aus Graphit angeordnet. Der Rückseitenkörper 28 gewährleistet eine gute Wärmeankopplung des SiC-Keimkristalls 10 an den nicht dargestellten Tiegel. Dadurch bildet sich kein unerwünschtes Wärmegefälle innerhalb des SiC-Keimkristalls 10 aus, das andernfalls zu einer Verschlechterung der aufwachsenden Kristallqualität führen könnte.

Sowohl der Rückseitenkörper 28 als auch der SiC-Keimkristall 10 werden durch eine seitliche Einfassung 30 mechanisch an der nicht dargestellten oberen Tiegelwand fixiert. Die Einfassung 30 hat dazu an ihrem unteren Ende mindestens einen Vorsprung 31, auf dem der SiC-Keimkristall 10 im Randbereich seiner Vorderseite 11 aufliegt. Auch die Einfassung 30 besteht aus Graphit.

Um eine thermische Degradation des SiC-Keimkristalls 10 zu vermeiden befindet sich zwischen einer Auflagefläche 29 des Rückseitenkörpers 28 sowie der seitlichen Einfassung 30 einerseits und dem SiC-Keimkristall 10 andererseits eine Schicht 40 aus Tantal. Die Schicht 40 ist beim Ausführungsbeispiel von Figur 1 eine lose eingelegte Tantal-Folie der Dicke von etwa 50 µm. Sie verhindert insbesondere ein Ausdiffundieren von Silicium aus dem SiC-Keimkristall 10 in das Graphit des Keimkristallhalters 20. Das Tantal der Schicht 40 ist nämlich gegenüber der aggressiven SiC-Gasphase und auch gegenüber dem Material des SiC-Keimkristalls chemisch stabil, so daß es zu keinen unerwünschten die Wachstumsqualität verschlechternden chemischen Reaktionen kommt.

Durch die Halterung des SiC-Keimkristalls 10 über die seitliche Einfassung 30 mit dem Vorsprung 31 wird eine sichere Fixierung im oberen Bereich des nicht dargestellten Züchtungstiegels gewährleistet. Damit ist die Voraussetzung für eine im Hinblick auf ein hochwertiges Kristallwachstum besonders günstige hängende Anordnung des SiC-Keimkristalls 10 im Züchtungstiegel gegeben.

In Figur 2 ist ein weiterer Keimkristallhalter 21 zur Halterung eines SiC-Keimkristalls 10a dargestellt, der sich von dem Keimkristallhalter 20 der Figur 1 im wesentlichen nur durch die Form des Vorsprungs 31 unterscheidet. Der Vorsprung 31 weist auf einer von der Kontaktfläche zum SiC-Keimkristall 10a abgewandten Seite eine erste Abschrägung 32 auf. Diese ist so ausgebildet, daß eine Wandstärke des Vorsprungs 32 mit zunehmenden Abstand von einem Zentrum des SiC-Keimkristalls 10a größer wird. Der Vorsprung 31 läuft in diesem Ausführungsbeispiel in einem spitzen Winkel aus.

Auch der durch den Keimkristallhalter 21 fixierte SiC-Keimkristall 10a unterscheidet sich geringfügig von dem SiC-Keimkristall 10 in Figur 1. Der SiC-Keimkristall 10a weist am Rand einen Randabsatz 13 auf, mit dem er auf dem Vorsprung 31 aufliegt. Die Vorderseite 11 des SiC-Keimkristalls 10a ragt dadurch ein Stück über den unteren Rand der seitlichen Einfassung 30 hinaus. Sowohl die erste Abschrägung 32 als auch der Randabsatz 13 verhindern damit ein Anwachsen des SiC-Volumeneinkristalls 15 an der seitlichen Einfassung 30 im Bereich des Vorsprungs 31. Da sich die Querschnittsfläche des SiC-Volumeneinkristalls 15 beim Wachstum leicht vergrößert, ist die in Figur 2 gezeigte Form der erste Abschrägung 32 besonders vorteilhaft, um ein Anwachsen des SiC-Volumeneinkristalls 15 sicher zu verhindern.

Figur 3 zeigt eine dritte Ausführungsform eines Keimkristallhalters 22 zur mechanischen Fixierung eines SiC-Keimkristalls 10b. Sowohl der Vorsprung 31 der seitlichen Einfassung 10 als auch der SiC-Keimkristall 10b weisen bei diesem Ausführungsbeispiel aneinander angepaßte zweite bzw. dritte Abschrägungen 33 bzw. 14 auf. Dadurch wird ein besonders guter Sitz des SiC-Keimkristalls 10b im Keimkristallhalter 22 erreicht.

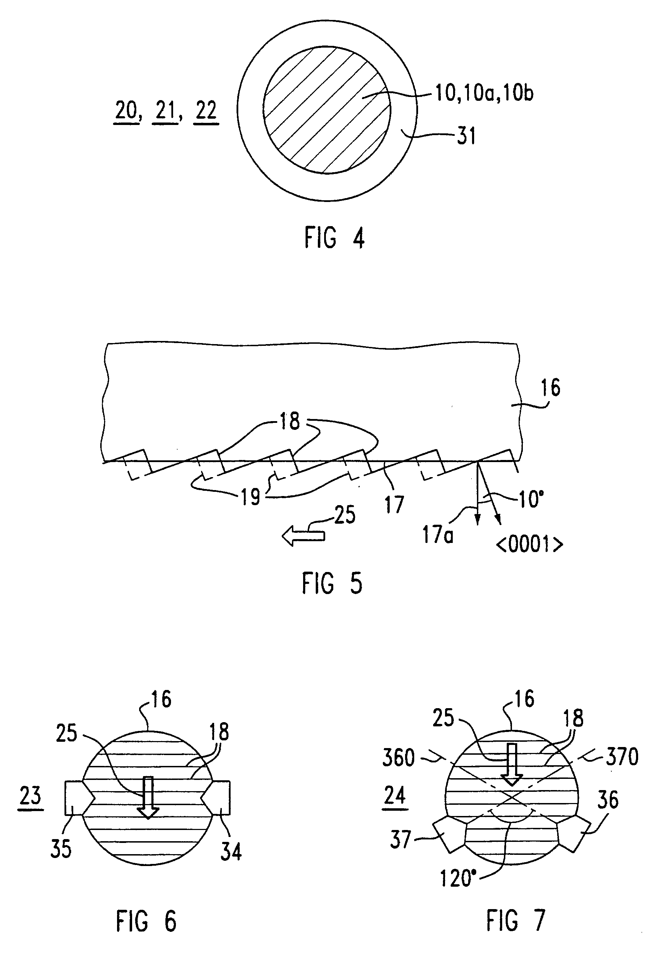

Figur 4 zeigt eine Ansicht von unten auf die Keimkristallhalter 20 bis 22 der Figuren 1 bis 3. Alle drei Keimkristallhalter 20, 21 und 22 haben eine runde Querschnittsgeometrie mit insbesondere zylinderförmiger Gestalt. Diese runde Geometrieform ist durch die ebenfalls runde Scheibenform der gehalterten SiC-Keimkristalle 10, 10a und 10b bedingt. Bei allen drei Keimkristallhaltern 20, 21 und 22 bildet der Vorsprung 31 eine Ringblende mit ringsum laufender Auflagefläche für den jeweiligen SiC-Keimkristall 10, 10a bzw. 10b.

Insbesondere bei einem fehlorientierten Keimkristall, dessen Oberfläche eine stufenförmige Struktur aufweist, kann eine solche ringsum laufende Ringblende jedoch eine Defektbildung im aufwachsenden SiC-Volumeneinkristall 15 begünstigen.

In Figur 5 ist ein Querschnitt durch einen fehlorientierten SiC-Keimkristall 16 dargestellt, dessen Oberflächennormale 17a um etwa 10° gegenüber einer <0001>-Richtung einer zugrundeliegenden α-SiC-Kristallstruktur geneigt ist. Diese Neigung, die bei anderen Ausführungsbeispielen auch bis zu 30° betragen kann, wird auch als Fehlorientierung bezeichnet. Sie bewirkt die Ausbildung von Stufen 18 an einer Oberfläche 17. Zu Beginn des Kristallwachstums lagern sich erste aufwachsende SiC-Partikel 19 bevorzugt in den Kehlen der Stufen 18 an. Dies erscheint wie ein Stufenfluß (step flow), dessen Ausbreitungsrichtung in Figur 5 mit dem Pfeil 25 bezeichnet ist. Es wurde nun erkannt, daß Defekte ausgehend von der Halterung am Rand bevorzugt in Richtung dieses Stufenflusses in den SiC-Volumeneinkristall 15 hineinwachsen.

Bei einem in Figur 6 gezeigten Keimkristallhalter 23 wird diese vom Rand ausgehende Defektbildung durch eine besonders günstige Form der seitlichen Einfassung 30 weitgehend unterdrückt. Der fehlorientierte SiC-Keimkristall 16 ist über zwei Stege 34 und 35 seitlich gefaßt. Die beiden Stege 34 und 35 sind so angeordnet, daß eine Verbindungslinie zwischen den beiden Stegen 34 und 35 praktisch parallel zu den Stufen 18, d.h. praktisch senkrecht zur Ausbreitungsrichtung 25 des Stufenflusses, gerichtet ist. Damit befindet sich jedoch gerade in dem Bereich, von dem ansonsten ein in den SiC-Kristall gerichtetes Defektwachstum bevorzugt ausgeht, keine mechanische Halterung. Dadurch entfällt aber die wesentliche Voraussetzung für diese Art der Defektbildung, so daß ein SiC-Volumeneinkristall 15 mit erheblich verringerter Defektdichte gezüchtet werden kann.

Durch eine andere in Figur 7 dargestellte Keimkristallhalterung 24 kann eine weitere Reduzierung der Defektdichte erreicht werden. Die Halterung erfolgt ebenfalls über zwei Stege 36 und 37. Wirkungslinien 360 und 370 dieser beiden Stege 36 bzw. 37 schließen einen stumpfen Winkel ein, der im Beispiel von Figur 7 etwa 120° beträgt.

Die gezeigten Keimkristallhalter 20 bis 24 lassen sich prinzipiell zur Züchtung eines SiC-Volumeneinkristalls 15 mit beliebigem Polytyp einsetzen. Alle gängigen SiC-Polytypen wie z.B. 4H-SiC, 6H-SiC oder 15R-SiC oder auch kubisches SiC vom 3C-SiC-Polytyp können damit gezüchtet werden.

## Patentansprüche

1. Keimkristallhalter zur Halterung eines SiC-Keimkristalls (10, 10a, 10b, 16) innerhalb eines Tiegels während einer Züchtung eines auf eine Vorderseite (11) des SiC-Keimkristalls (10, 10a, 10b, 16) mittels einer SiC-Gasphase aufwachsenden SiC-Volumeneinkristalls (15) umfassend mindestens
- einen Rückseitenkörper (28) mit einer Auflagefläche (29) für eine Rückseite (12) des SiC-Keimkristalls (10, 10a, 10b, 16) und
- eine seitliche Einfassung (30) für den Rückseitenkörper (28) und den SiC-Keimkristall (10, 10a, 10b, 16), wobei
- die seitliche Einfassung (30) wenigstens einen Vorsprung (31) enthält, auf dem der SiC-Keimkristall (10, 10a, 10b, 16) in einem Randbereich seiner Vorderseite (11) aufliegt, und
- die seitliche Einfassung (30) mit einer Schicht (40) versehen ist, die aus einem gegenüber den Komponenten der SiC-Gasphase chemisch stabilen und bei einer während der Züchtung herrschenden Temperatur nichtschmelzenden Material der Gruppe von Tantal, Wolfram, Niob, Molybdän, Rhenium, Iridium, Ruthenium, Hafnium und Zirkon oder aus einem solchen Material mit wenigstens einem Element der Gruppe besteht.

2. Keimkristallhalter nach Anspruch 1, **dadurch gekennzeichnet, daß** der Vorsprung (31) an einer von der Auflagefläche für den SiC-Keimkristall (10a) abgewandten Seite mit einer ersten Abschrägung (32) versehen ist, so daß eine Wandstärke des Vorsprungs (31) in Richtung des Zentrums des zu halternden SiC-Keimkristalls (10a) immer mehr abnimmt.

3. Keimkristallhalter nach Anspruch 1 oder 2, **dadurch gekennzeichnet, daß** der Vorsprung (31) an einer dem SiC-Keimkristall (10b) zugewandten Seite mit einer zweiten Abschrägung (33) versehen ist, so daß sich eine schräge Auflagefläche für den SiC-Keimkristall (10b) ergibt.

4. Keimkristallhalter nach einem der vorhergehenden Ansprüche, **dadurch gekennzeichnet, daß** der Rückseitenkörper (28) und die seitliche Einfassung (30) zumindest weitgehend aus Graphit bestehen.

5. Keimkristallhalter nach einem der vorhergehenden Ansprüche, **dadurch gekennzeichnet, daß** zumindest der Rückseitenkörper (28) mit einer die Auflagefläche (29) bildenden Schicht (40) versehen ist, die aus einem Material der Gruppe von Tantal, Wolfram, Niob, Molybdän, Rhenium, Iridium, Ruthenium, Hafnium und Zirkon oder aus einem Material mit wenigstens einem Element der Gruppe besteht.

6. Keimkristallhalter nach einem der vorhergehenden Ansprüche, **dadurch gekennzeichnet, daß** der Rückseitenkörper (28) und der zu halternde SiC-Keimkristall (10, 10a, 10b, 16) eine runde Querschnittsfläche aufweisen.

7. Keimkristallhalter nach einem der vorhergehenden Ansprüche, **dadurch gekennzeichnet, daß** die seitliche Einfassung (30) eine zylinderförmige Gestalt aufweist.

8. Keimkristallhalter nach einem der Ansprüche 1 bis 6, **dadurch gekennzeichnet, daß** die seitliche Einfassung (30) in Stegform ausgebildet ist und zur Halterung eines SiC-Keimkristalls (16) mit einer runden Querschnittsfläche bestimmt ist.

9. Keimkristallhalter nach Anspruch 8, **dadurch gekennzeichnet, daß** die seitliche Einfassung (30) zwei Stege (34, 35, 36, 37) enthält, wobei der Vorsprung zur Auflage des SiC-Keimkristalls (16) jeweils am unteren Ende der Stege (34, 35, 36, 37) angeordnet ist.

10. Keimkristallhalter nach Anspruch 9, **dadurch gekennzeichnet, daß** die beiden Stege (34, 35) längs einer Stufenhauptrichtung eines zwischen ihnen positionierbaren, fehlorientierten SiC-Keimkristalls (16) mit stufenförmig strukturierter Vorderseite (11) angeordnet sind.

11. Keimkristallhalter nach Anspruch 9, **dadurch gekennzeichnet, daß** die beiden Stege (36, 37) Wirkungslinien (360, 370) haben, die einen stumpfen Winkel einschließen.

## Claims

1. Seed crystal holder to hold a SiC seed crystal (10, 10a, 10b, 16) within a crucible during growth of a SiC bulk single crystal (15) growing on a front side (11) of the SiC seed crystal (10, 10a, 10b, 16) by means of a SiC gas phase, comprising at least
- a rear side body (28) with a supporting surface (29) for a rear side (12) of the SiC seed crystal (10, 10, 10b, 16) and
- a lateral enclosure (30) for the rear side body (28) and the SiC crystal (10, 10a, 10b, 16), whereby
- the lateral enclosure (30) contains at least one projection (31), on which the SiC seed crystal (10, 10a, 10b, 16) rests in an edge area of its front side (11), and
- the lateral enclosure (30) is provided with a layer (40) which consists of a material from the group of tantalum, tungsten, niobium, molybdenum, rhenium, iridium, ruthenium, hafnium and zirconium which compared to the components of the SiC gas phase is chemically stable and which does not melt at a temperature prevailing during the growth, or of such a material with at least one element from the group.

2. Seed crystal container according to Claim 1, **characterised in that** the projection (31) on a side facing away from the supporting surface for the SiC seed crystal (10a) is provided with a first chamfer (32), so that a wall thickness of the projection (31) continually decreases in the direction of the centre of the SiC seed crystal (10a) to be held.

3. Seed crystal holder according to Claim 1 or 2, **characterised in that** the projection (31) on a side facing towards the SiC seed crystal (10b) is provided with a second chamfer (33), so that an inclined supporting surface is produced for the SiC seed crystal (10b).

4. Seed crystal holder according to one of the preceding claims, **characterised in that** the rear side body (28) and the lateral enclosure (30) consist at least largely of graphite.

5. Seed crystal holder according to one of the preceding claims, **characterised in that** at least the rear side body (28) is provided with a layer (40) forming the supporting surface (29), said layer consisting of a material from the group of tantalum, tungsten, niobium, molybdenum, rhenium, iridium, ruthenium, hafnium and zirconium or of a material containing at least one element from the group.

6. Seed crystal holder according to one of the preceding claims, **characterised in that** the rear side body (28) and the SiC seed crystal (10, 10a, 10b,16) to be held have a round cross-sectional area.

7. Seed crystal holder according to one of the preceding claims, **characterised in that** the lateral enclosure (30) has a cylindrical construction.

8. Seed crystal holder according to one of Claims 1 to 6, **characterised in that** the lateral enclosure (30) is in the form of a web and is intended to hold a SiC seed crystal (16) with a round cross-sectional area.

9. Seed crystal holder according to Claim 8, **characterised in that** the lateral enclosure (30) contains two webs (34, 35, 36, 37), whereby the projection to support the SiC seed crystal (16) is in each case arranged at the lower end of the webs (34, 35, 36, 37).

10. Seed crystal holder according to Claim 9, **characterised in that** the two webs (34, 35) are arranged along a stepped main direction of an incorrectly oriented SiC seed crystal (16) which can be positioned between them, said crystal having a stepped front side (11).

11. Seed crystal holder according to Claim 9, **characterised in that** the two webs (36, 37) have action lines (360, 370) which enclose an obtuse angle.

## Revendications

1. Porte-cristal germe de maintien d'un cristal germe (10, 10a, 10b, 16) de SiC dans un creuset pendant une croissance d'un monocristal (15) de volume en SiC croissant sur un côté (11) avant du cristal germe (10, 10a, 10b, 16) de SiC au moyen d'une phase gazeuse de SiC comprenant au moins :
- une pièce (28) de côté arrière ayant une surface (29) d'appui d'un côté (12) arrière du cristal germe (10, 10a, 10b, 16) de SiC et
- un enchâssement (30) latéral du corps (28) de côté arrière et du cristal germe (10, 10a, 10b, 16) de SiC,
- l'enchâssement (30) latéral ayant au moins une saillie (31) sur laquelle le cristal germe (10, 10a, 10b, 16) de SiC s'applique dans une partie marginale de son côté (11) avant et
- l'enchâssement (30) latéral étant muni d'une couche (40) qui est en un matériau stable chimiquement vis-à-vis des constituants de la phase gazeuse de SiC et ne fondant pas à une température régnant pendant la croissance, choisi dans le groupe du tantale, du tungstène, du niobium, du molybdène, du rhénium, de l'iridium, du ruthénium, de l'hafnium et du zirconium ou en un matériau de ce genre ayant au moins un élément du groupe.

2. Porte-cristal germe suivant la revendication 1, **caractérisé en ce que** la saillie (31) est munie sur un côté éloigné de la surface d'appui du cristal germe (10a) de SiC d'un premier biseau (32), de sorte qu'une épaisseur de paroi de la saillie (31) diminue de plus en plus en direction du sens du cristal germe (10a) de SiC à maintenir.

3. Porte-cristal germe suivant la revendication 1 ou 2, **caractérisé en ce que** la saillie (31) est munie d'un côté tourné vers le cristal germe (10b) de SiC d'un deuxième biseau (33) de manière à obtenir une surface d'appui inclinée pour le cristal germe (10b) de SiC.

4. Porte-cristal germe suivant l'une des revendications précédentes, **caractérisé en ce que** la pièce (28) de côté arrière et l'enchâssement (30) latéral sont, au moins dans une grande mesure, en graphite.

5. Porte-cristal germe suivant l'une des revendications précédentes, **caractérisé en ce qu'**au moins la pièce (28) de côté arrière est munie d'une couche (40) qui forme la surface (29) d'appui et qui est en un matériau choisi dans le groupe du tantale, du tungstène, du niobium, du molybdène, du rhénium, de l'iridium, du ruthénium, de l'hafnium et du zirconium ou en un matériau ayant au moins un élément du groupe.

6. Porte-cristal germe suivant l'une des revendications précédentes, **caractérisé en ce que** la pièce (28) de côté arrière et le cristal germe (10, 10a, 10b, 16) de SiC à maintenir ont une surface de section transversale qui est circulaire.

7. Porte-cristal germe suivant l'une des revendications précédentes, **caractérisé en ce que** l'enchâssement (30) latéral a la forme d'un cylindre.

8. Porte-cristal germe suivant l'une des revendications 1 à 6, **caractérisé en ce que** l'enchâssement (30) latéral est constitué sous forme de barrettes et est destiné à maintenir un cristal germe (16) de SiC, dont la surface de la section transversale est circulaire.

9. Porte-cristal germe suivant la revendication 8, **caractérisé en ce que** l'enchâssement (30) latéral a deux barrettes (34, 35, 36, 37), la saillie d'appui du cristal germe (16) de SiC étant placé, respectivement, à l'extrémité inférieure des barrettes (34, 35, 36, 37).

10. Porte-cristal germe suivant la revendication 9, **caractérisé en ce que** les deux barrettes (34, 35) sont placées le long d'une direction principale de paliers d'un cristal germe (16) de SiC mal orientées et pouvant être mises en position entre elles, le cristal germe ayant un côté avant (11) structuré en forme de paliers.

11. Porte-cristal germe suivant la revendication 9, **caractérisé en ce que** les deux barrettes (36, 37) ont des lignes d'action qui font entre elles un angle obtus.
